Europäisches Patentamt

(19) European Patent Office

Office européen des brevets

(11) Numéro de publication : **0 169 125**
**B1**

(12) **FASCICULE DE BREVET EUROPÉEN**

(45) Date de publication du fascicule du brevet :
**30.08.89**

(21) Numéro de dépôt : **85401279.6**

(22) Date de dépôt : **25.06.85**

(51) Int. Cl.⁴ : **H 05 C   3/00**, G 01 R 31/02

(54) **Clôture électrique constituée par un réseau des lignes de fil conducteur parcourue par un courant électrique.**

(30) Priorité : **16.07.84 FR 8411673**

(43) Date de publication de la demande :
**22.01.86 Bulletin 86/04**

(45) Mention de la délivrance du brevet :   ·
**30.08.89 Bulletin 89/35**  ·

(84) Etats contractants désignés :
**BE DE GB**

(56) Documents cités :
**FR–A– 2 314 502
FR–A– 2 319 134
US–A– 3 772 529**

(73) Titulaire : **SANTERNE S.A.
23, 25 rue du Dépôt
F-62033 Arras Cedex (FR)**

(72) Inventeur : **Fruleux, Alain
4 rue Baudimont
F-62000 Arras (FR)**
Inventeur : **Marreaud, Christian
12 Place de Rouen
F-62217 Achicourt (FR)**

(74) Mandataire : **Ecrepont, Robert
Cabinet Ecrepont 12 Place Simon Vollant
F-59800 Lille (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

L'invention concerne une clôture électrifiée constituée par un réseau de lignes de fil conducteur notamment parcouru par un courant électrique.

De telles clôtures sont actuellement utilisées de manière courante pour délimiter une surface donnée, par exemple pour protéger des installations, des matériels, des bâtiments.

Elles ont pour but d'empêcher l'accès dans la surface qu'elles délimitent, ou d'interdire la sortie de cette surface, elles ont également pour but généralement de déclencher une alarme en cas de tentatives de franchissement ou de sabotage.

Les clôtures de ce type existants actuellement décèlent une telle tentative par détection d'un défaut dans le réseau de lignes, notamment provoquée par une coupure, le contact direct d'un être humain avec un fil, ou par un court-circuit réalisé entre différents fils.

L'invention se rapporte plus précisément aux clôtures où il y a circulation effective d'un courant dans le réseau de lignes et où il y a mesure directe ou indirecte de ce courant et de la tension.

On peut citer par exemple le brevet FR-A-2 458 078, qui propose un réseau de fils électrifiés présentant d'un côté une extrémité d'entrée et de l'autre côté une extrémité de sortie, le dit réseau étant parcouru par un courant à partir d'une source d'alimentation, le réseau comprenant par ailleurs des moyens de détection de défauts de coupure et d'isolement, des moyens pour générer une répartition de l'une au moins des grandeurs qui sont le potentiel au niveau des extrémités des lignes des fils du réseau et le courant dans les dites lignes des fils du réseau et des moyens pour contrôler la dite répartition au niveau de l'extrémité d'au moins l'une des lignes.

Toutefois, cette clôture met en œuvre deux sources d'alimentation.

Ces sources sont notamment deux enroulements secondaires d'un transformateur, elles alimentent chacune une partie du réseau de fils électrifiés.

Cette clôture opère par mesure des tensions de lignes et du courant circulant dans chaque partie du réseau, ainsi que par mesure d'une interférence éventuelle entre les deux réseaux.

Elle permet de détecter la coupure de l'un des fils, une mise en défaut de l'un des fils par rapport à la terre, elle permet en outre de détecter la mise en court-circuit de deux fils appartenant respectivement à une partie différente du réseau de fils c'est à dire alimentés par des sources différentes.

Un inconvénient d'une telle clôture est qu'elle nécessite deux sources d'alimentation et ne permet pas de détecter la mise en court-circuit de deux fils alimentés par une même source d'alimentation ou par le même enroulement d'un transformateur.

Un autre inconvénient d'une telle clôture est qu'elle n'assure pas en général l'isolement galvanique entre le circuit d'alimentation basse tension et le circuit de la clôture de fils électrifiés.

La détection s'opère en effet par mesure de grandeur électrique dans le circuit de la clôture et par traitement électrique ou électromécanique de ces mesures électriques.

Un des buts de la présente invention est de remédier à ces inconvénients et de proposer une clôture électrifiée qui puisse être alimentée par une seule source d'alimentation, qui permette la détection de défauts d'isolement entre fils et entre fils et terre et de coupure de chacun de ces fils.

D'autres buts et avantages de la présente invention apparaîtront au cours de la description qui va suivre, qui n'est cependant donnée qu'à titre indicatif et qui n'a pas pour but de limiter l'invention.

La clôture électrifiée selon l'invention est constituée par un réseau de lignes de fil conducteur, chacune des lignes présentant d'un côté une extrémité d'entrée et de l'autre côté une extrémité de sortie et étant parcourue par un courant à partir d'une seule source d'alimentation, le réseau comprenant par ailleurs des moyens de contrôle de défauts de coupure des lignes et d'isolement entre les lignes.

Elle est caractérisée par le fait que les moyens de contrôle sont couplés par des moyens d'isolation galvanique à des moyens de traitement et par le fait que les moyens de contrôle de défauts comprennent des cellules de détection des défauts disposées dans le réseau de façon à générer une répartition de potentiels au niveau des extrémités d'entrée ou de sortie des lignes, lesdites cellules permettant de contrôler ladite répartition au niveau desdites extrémités des lignes.

L'invention sera mieux comprise à l'aide de la description ci-dessous, à titre d'exemple non limitatif, en regard du dessin ci-annexé qui représente schématiquement :

figure 1 : la clôture selon l'invention,

figure 2 : une forme préférée de réalisation de l'invention des moyens de détection de défauts de la clôture de la figure 1,

figure 3 : une forme préférée de réalisation d'un autre moyen de détection de défauts,

figure 4 : un réseau de fils électrifiés pourvu de moyens de détection de défauts selon l'invention,

figure 5 : une forme préférée de réalisation des moyens de détection de défauts de la nappe de fils par rapport à la terre.

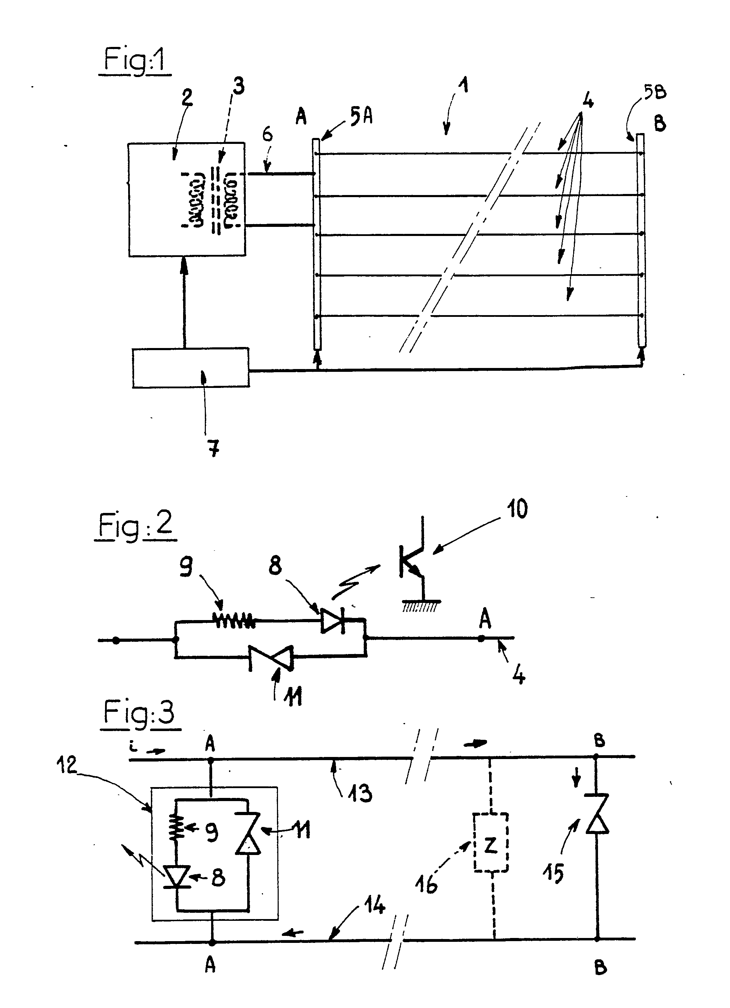

La figure 1 représente de manière schématique une clôture constituée d'un réseau 1 de lignes de fil conducteur, alimentée par une source d'alimentation 2.

La source 2 génère dans le réseau de fils électrifiés 1 le passage d'un courant de type continu, alternatif ou impulsionnel.

Elle est de tout type approprié, à la portée de l'homme de l'art, et, tel que cela est représenté en traits interrompus, elle peut présenter un transformateur 3 qui élève la tension et dont le circuit primaire est soumis à une tension alternative ou impulsionnelle.

En se référant à la figure 1, les lignes de fil conducteur 4 sont parallèles entre elles et s'étendent entre des éléments 5A et 5B, par exemple des poteaux ou des barres d'alignement ou d'arrêt.

Ceci, naturellement, n'est pas limitatif, et tel que cela paraîtra ultérieurement, l'invention s'applique également à une clôture comprenant une ligne de fil conducteur ainsi qu'à une clôture comprenant plusieurs nappes de lignes de fil conducteur, telle que celle représentée en figure 1.

Le réseau 1 comprend également au moins un fil de raccordement 6 à la source, le retour pouvant se faire également par un fil ou par la terre.

Pour faciliter la compréhension de la description, les extrémités des lignes de fil conducteur 4 reliées à l'élément 5A seront appelées extrémité A ou extrémité d'entrée et les extrémités des lignes de fil 4 reliées à l'élément 5B seront nommées extrémité B ou extrémité de sortie.

De même, on ne considèrera que les instants correspondant à une circulation effective d'un courant dans la clôture dans un sens conventionnel positif orienté globalement pour les figures de gauche à droite ou de haut en bas.

Ce courant est généré par une tension continue par l'impulsion d'une tension impulsionnelle ou l'une des alternances d'une tension alternative.

L'homme de l'art est à même de déduire ce qui se passe en dehors des instants considérés.

Les moyens de détection de défauts qui permettent de déceler un défaut d'isolement du réseau de lignes de fil, une tentative de franchissement ou une tentative de sabotage, sont des moyens pour générer une répartition de potentiels au niveau des extrémités A, B des lignes de fils 4 du réseau 1, et de courant dans lesdites lignes de fils du réseau 1, et d'autre part des moyens pour contrôler ladite répartition de potentiel et de courant au niveau de l'extrémité A, B d'au moins l'une des lignes 4.

En se référant à la figure 2, les moyens de contrôle sont constitués par une diode électroluminescente 8 monté en série avec une résistance 9.

La diode 8 est par exemple une photo-diode qui est couplée à un photo-transistor 10.

Elle peut également être une diode laser couplée à un photo-transistor 10 par l'intermédiaire d'une fibre optique. De préférence, un composant tel une diode Zéner 11 est placé en parallèle aux bornes de l'ensemble diode 8 résistance 9 de manière à limiter le courant circulant dans la diode et ainsi à protéger ladite diode électroluminescente 8.

Ceci est connu de l'homme de l'art.

Lorsque la cellule constituée de la diode électro-luminescente 8, la résistance 9 et de la diode Zéner 11 est parcourue par un courant circulant dans le sens passant de la diode 8, cette dernière émet des radiations lumineuses qui sont captées par le photo-transistor 10.

L'information de passage du courant dans la cellule est ainsi transmise aux moyens de traitement 7 par l'intermédiaire du photo-transistor 10.

Le couplage optique entre la diode 8 et le photo-transistor 10 réalise l'isolation galvanique souhaitée entre le réseau de fils électrifiés 1 et les moyens de traitement 7.

L'utilisation d'une diode laser ou « DEL » et d'une fibre optique comme moyen de transmission permet d'éloigner les composants et donc améliore encore l'isolation galvanique.

Elle permet en particulier d'atteindre des valeurs supérieures à vingt cinq kilovolts.

La cellule qui vient d'être décrite peut avantageusement être placée en série avec une ligne de fil électrifié 4, en amont de son extrémité A.

L'éclairement de la diode 8 témoigne de la circulation d'un courant dans la ligne 4 à laquelle la cellule est associée, et donc la continuité électrique de cette ligne.

Par contre, une interruption de l'éclairement de la diode 8 informe d'une coupure de la ligne de fil correspondante 4. Dans ce dernier cas, les moyens de traitement 7 qui sont situés en aval du photo-transistor 10 peuvent être de tout type apte à réagir comme dans le cas précédent à un blocage du photo-transistor 10 et à commander une alarme appropriée. Dans la figure 3, une cellule 12 semblable à celle décrite relativement à la figure 1, relie deux lignes de fils repérées en 13 et 14.

De préférence, la liaison des lignes 13, 14 par la cellule 12 est réalisée au niveau de leur extrémité respective A.

Au niveau de leur extrémité B les deux lignes 13, 14 sont portées à des potentiels différents.

Dans l'hypothèse où le potentiel de la ligne 13 est supérieur à celui de la ligne 14, la cellule 12 est orientée comme dans la figure 3 ; ceci n'est cependant que conventionnel.

La chute de tension entre les deux lignes peut être obtenue de manière résistive, par la résistance propre de l'une des lignes ou par une résistance rapportée.

Cependant, tel que cela est représenté en figure 3, elle est de préférence obtenue par une diode Zéner 15 qui relie les extrémités B des deux lignes 13 et 14.

Globalement, pour les deux lignes 13 et 14 et la cellule 12, le courant entre par l'extrémité A de la ligne 13, parcoure la ligne 13 de A vers B, traverse la diode Zéner 15 ce qui provoque cette chute de tension, et parcoure la ligne 14 de B vers A.

Les éléments qui constituent la cellule 12 sont déterminés de manière à ce que, en fonctionnement normal, et donc lorsque la cellule est parcourue par le courant résultant de la seule différence de tension entre les lignes, sa diode électro-luminescente 8 soit allumée.

Par contre, lorsque les deux lignes 13 et 14 sont reliées par une impédance Z repérée en 16, la diode Zéner 15 se trouve en partie court-circuitée et la différence de potentiel entre les extrémités A des lignes 13 et 14 diminue, ce qui provoque l'extinction de la diode électro-luminescente 8.

Cette information est transmise aux moyens de traitement 7, par exemple par un photo-transistor (non représenté).

Les moyens de traitement peuvent être de tout type apte à réagir comme dans le cas présent à l'extinction de la diode 8 pour commander une alarme appropriée de manière semblable à sa réaction à la coupure de la ligne.

Cependant, avantageusement, ils peuvent présenter des seuils multiples échelonnés qui permettent ainsi de déceler plusieurs niveaux de défauts d'isolement entre deux lignes distinctes et donc de les différencier.

Dans le cas où la cloture présente une pluralité de lignes 4, les extrémités A de ces lignes sont reliées deux par deux par des cellules semblables à la cellule 12, et les informations recueillies par les photo-transistors sont traitées individuellement, ou bien les photo-transistors sont placés en série les uns derrière les autres et l'information est traitée globalement.

La clôture telle celle de la figure 1, peut présenter en amont des extrémités A de chacune de ces lignes, une cellule telle que celle qui a été décrite relativement à la figure 2 et des cellules telles que celles de la figure 3 reliant deux à deux les extrémités A de ses lignes.

Une telle disposition assure une détection des coupures et des défauts d'isolement dans les lignes 4.

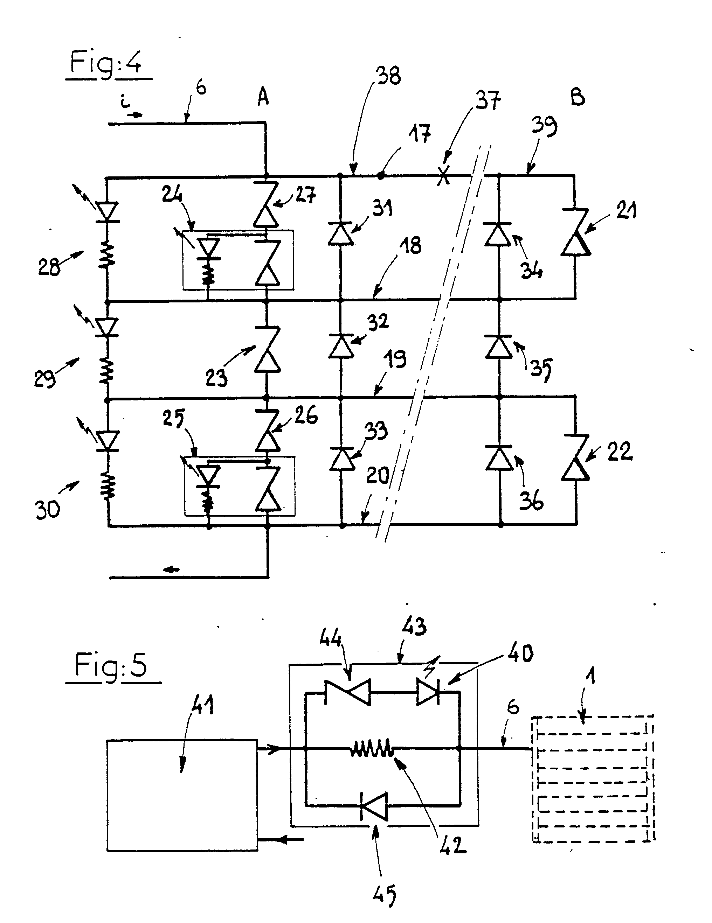

Une variante de cette disposition est représentée en figure 4.

Selon cette variante, les lignes de fils qui composent le réseau, sont associées électriquement deux par deux.

Ainsi, la figure 4 représente les lignes 17, 18 d'une part, et les lignes 19 et 20 d'autre part.

Il faut remarquer que l'association de ces lignes deux par deux est une association de type électrique et que les lignes associées ne sont pas nécessairement juxtaposées dans le réseau de fils.

Les lignes de fils sont portées à des potentiels différents au niveau de leurs extrémités A et B.

Cette chute de potentiel peut être obtenue à partir de la résistance des fils eux-même, éventuellement de résistances additives, ou bien tel que cela est représenté en figure 4, au moyen de diodes Zéner 21, 22, 23.

Ces diodes relient les extrémités B de deux lignes associées électriquement et les extrémités A de deux lignes appartenant à des ensembles adjacents.

Ainsi, la diode Zéner 21 relie les extrémités B des lignes 17, 18, la diode Zéner 22 les lignes 19 et 20 et la diode Zéner 23 relie les extrémités A des lignes 18 et 19.

Les moyens de contrôle comprennent des cellules de détection de coupure dans deux lignes associées électriquement, c'est à dire la cellule 24 pour les lignes 17, 18, et la cellule 25 pour les lignes 19, 20.

Les cellules 24 et 25 sont semblables à celles décrites relativement à la figure 2 mais leur fonctionnement est sensiblement différent.

En effet, ces cellules relient les extrémités A de deux lignes associées électriquement, en série avec une diode Zéner dont la valeur caractéristique de tension est au moins égale à celle de la diode qui relie les extrémités B de ces lignes.

Ainsi, la cellule 24, en série avec une diode Zéner 27, relie les extrémités A des lignes 17 et 18 et la cellule 25, en série avec une diode Zéner 26, relie les extrémités A des lignes 19, 20.

La diode Zéner 27 et la diode de la cellule 24 sont orientées dans le même sens et ces diodes sont orientées parallèlement à la diode Zéner 21 qui relie les extrémités B des lignes 17 et 18.

La valeur caractéristique de tension de la diode 27 est au moins égale à celle de la diode 21.

En régime normal, le courant circule dans la ligne 17 de A vers B, traverse la diode 21 et revient par la ligne 18 de B vers A.

Aucun courant ne traverse la diode électro-luminescente de la cellule 24.

Par contre, en cas de coupure d'une des lignes 17 ou 18, la diode 27 prend le relais de la diode 21 et le courant passe de l'extrémité A de la ligne 17 à celle de la ligne 18 via la diode 27 et la cellule 24.

Ceci provoque l'allumage de la diode électro-luminescente et, par l'intermédiaire des moyens de traitement, excite une alarme correspondante.

Une disposition semblable est située entre les lignes 19 et 20 et, d'une manière générale, entre deux lignes associées électriquement.

Les extrémités A des différentes lignes sont par ailleurs reliées par une cellule 28, 29, 30 semblable à la cellule 12 de la figure 3 mais qui, en parallèle sur la diode électro-luminescente et la résistance, ne comporte pas de diode Zéner distincte de celles précitées 23, 26, 27.

De telles cellules sont repérées en 28 pour les extrémités A des lignes 17 et 18, en 29 pour les lignes 18, 19 et en 30 pour les lignes 19, 20.

Le fonctionnement de ces cellules est semblable à celui qui a été décrit relativement en figure 3.

Il faut cependant remarquer que, par rapport au cas précédent, la diode Zéner 11 est remplacée ou bien par la diode 27 en série avec la diode de la cellule 24 pour la cellule 28, ou bien par la diode Zéner 23 pour la cellule 29 ou enfin par la diode 26 en série avec la diode de la cellule 25 pour la cellule 30 ou la diode Zéner 22.

En outre, il faut souligner qu'un défaut d'isolement entre deux lignes qui ne sont pas électriquement adjacentes, et, par exemple, les lignes 17 et 20, se traduit par l'extinction des diodes électro-luminescentes des cellules de détection de défauts qui sont placées entre ces deux lignes, c'est à dire celles des cellules 28, 29 et 30.

La figure 4 présente par ailleurs des diodes 31 à 36 qui relient deux à deux les extrémités A des lignes et les extrémités B des lignes.

Ces diodes ont pour but de permettre un passage du courant de ligne en sens inverse, par exemple, pendant les alternances négatives pour une tension sinusoïdale.

A cet effet, elles protègent les cellules précédemment décrites.

Elles servent également à maintenir sous tension les deux parties d'une ligne qui aurait été coupée.

Ainsi, par exemple, en cas de coupure de la ligne 17, schématisé en 37, non seulement la partie 38 de la ligne située du côté de l'extrémité A reste sous tension mais aussi l'autre partie 39 située vers l'extrémité B et dont le maintien sous tension est assuré par l'intermédiaire de la diode Zéner 27, de la cellule 24, de la ligne 18, puis de la diode 34 qui assure la continuité entre les extrémités B. Naturellement, la diode électro-luminescente de la cellule 24 signale la coupure de la ligne aux moyens de traitement 7. Plus généralement, les diodes 31 à 36 permettent un maintien sous tension de l'ensemble des lignes de la nappe 1, en cas de coupures multiples, jusqu'à la coupure de la dernière ligne.

Il faut souligner que les moyens de contrôle représentés en figure 4 génèrent une répartition de potentiels et contrôlent cette répartition.

Ces moyens comprennent des moyens passifs tels que les résistances ou les diodes Zéner, et ils comprennent en outre des moyens actifs c'est-à-dire notamment des diodes électroluminescentes qui signalent et transmettent l'état de la nappe aux moyens de traitement 7.

De préférence, les moyens actifs sont tous situés d'un même côté du réseau; par exemple le côté des extrémités A, ce qui permet de simplifier le raccordement du réseau aux moyens de traitement 7, en effet, les fils électriques et/ou les fibres optiques ou les autres moyens de liaison aboutissent à une même base de support de la nappe.

Avantageusement, les moyens actifs et les moyens passifs seront respectivement cachés à la vue et seront par exemple logés dans un coffret ou noyés dans de la résine ; ceci est à la portée de l'homme de l'art.

La figure 5 représente une variante de réalisation des moyens de contrôle, plus particulièrement destinée à détecter un défaut dans l'isolement de la nappe par rapport à la terre.

La cellule 40 est connectée au niveau d'un fil de raccordement 6 entre la borne de sortie de la source d'alimentation 41 et l'extrémité d'entrée du réseau 1 de fils.

Elle pourrait être placée entre la sortie du réseau 1 et la borne de retour à la source 41.

La cellule 40 présente principalement une résistance 42, aux bornes de laquelle on contrôle la tension au moyen de la diode électro-luminescente 43 et de la diode Zéner 44 destinée à définir un seuil prédéterminé de tension.

Elle comprend éventuellement une diode 45 de protection et de retour.

Un isolement correct du réseau de fils par rapport à la terre se traduit au niveau de la source par la consommation d'un courant i qui provoque une baisse de tension déterminée aux bornes de la résistance 42, ce qui se traduit par un éclairement déterminé de la diode électro-luminescente 43. Tout défaut d'isolement du réseau par rapport à la terre se traduit par une modification du courant est donc de l'éclairement de la diode électro-luminescente 43, ce qui est transmis aux moyens de traitement 7, par exemple par l'intermédiaire d'un photo-transistor.

Il est possible d'utiliser plusieurs cellules correspondant à des seuils préréglés différents.

A cet effet, les moyens de contrôle qui viennent d'être décrits, mettent en œuvre pour la transmission des diodes électro-luminescentes, par exemple des photo-diodes ou des diodes laser, associées à des photo-transistors éventuellement par l'intermédiaire d'une fibre optique.

On pourrait très bien adopter d'autres moyens de transmission appropriés, optiques, radio-électriques, électriques, électro-mécaniques, ceci est à la portée de l'homme de l'art. Cependant, les moyens de transmission adoptés présentent des caractéristiques d'isolement qui garantissent un isolement galvanique, entre le circuit de la clôture et le circuit d'alimentation primaire, de préférence supérieur à vingt cinq kilovolts.

En outre, il faut remarquer que le traitement des informations transmises par ces moyens tient compte de la nature de la tension appliquée au réseau de lignes, en particulier dans le cas d'une tension sinusoïdale ou impulsionnelle.

Les composants électroniques qui constituent les différentes cellules des moyens de contrôle dépendent principalement du courant qui circule dans le réseau de fils, et accessoirement de la tension à laquelle est élevé globalement le réseau. Leur nature précise ainsi que leurs caractéristiques peuvent être facilement déterminées par l'homme de l'art.

En outre, le réseau de fils électrifiés peut comprendre une pluralité de lignes de fils telles que les lignes 17 à 20, éventuellement regroupées selon des tronçons, juxtaposés horizontalement ou verticalement ou même mélangés entre eux. Naturellement, la présente description n'est donnée qu'à titre indicatif et on pourrait adopter d'autres mises en œuvre de l'invention sans pour autant sortir du cadre de celle-ci.

## Revendications

1. Clôture électrifiée constituée par un réseau (1) de lignes de fil conducteur (4), chacune des lignes présentant d'un côté une extrémité d'entrée (A) et de l'autre côté une extrémité de sortie (B) et étant parcourue par un courant à partir d'une seule source d'alimentation (2), le réseau comprenant par ailleurs des moyens de contrôle de défauts de coupure des lignes et d'isolement entre les lignes, caractérisée par le fait que les moyens de contrôle sont couplés par des moyens d'isolation galvanique à des moyens de traitement (7) et par le fait que les moyens de contrôle de défauts comprennent, des cellules de détection des défauts (11, 12, 24, 25, 28, 29, 30, 40) disposées dans le réseau de façon à générer une répartition de potentiels au niveau des extrémités d'entrée ou de sortie (A, B) des lignes (4, 13, 14, 17 à 20), lesdites cellules permettant de contrôler ladite répartition au niveau desdites extrémités (A, B) des lignes (4, 13, 14, 17 à 20).

2. Clôture électrifiée selon la revendication 1 caractérisée par le fait que les cellules de détection des défauts comprennent des moyens actifs de transmission vers les moyens de traitement (7) et des moyens passifs, et que l'ensemble des moyens actifs est situé du côté d'une même extrémité (A) des lignes de fils (4, 13, 14, 17 à 20) du réseau (1).

3. Clôture électrifiée selon la revendication 1 ou 2 caractérisée par le fait que les cellules de contrôle sont situées en série avec chacune des lignes de fil conducteur (4), en amont de son extrémité d'entrée (A) à laquelle elles sont par ailleurs connectées.

4. Clôture électrifiée selon l'une quelconque des revendications 1 à 3 caractérisée par le fait que les cellules sont disposées dans le réseau de façon à établir une différence de potentiel entre au moins les extrémités d'entrée (A) de deux lignes successives (13, 14, 17 à 20) et de façon à relier les extrémités d'entrée (A) de deux lignes successives (13, 14, 17 à 20).

5. Clôture électrifiée selon la revendication 1 caractérisée par le fait que les lignes de fils (4) sont associées électriquement deux par deux (17/18, 19/20) au moyen des cellules, lesdites cellules étant connectées en série avec des moyens à seuil de tension et reliant les extrémités (A) d'entrée de façon à établir une différence de potentiel entre les extrémités d'entrée (A) de deux lignes de fils associées électriquement (17/18, 19/20), et par le fait que ledit seuil est au moins égal à la différence de potentiel précédemment citée.

6. Clôture électrifiée selon la revendication 4 ou 5 caractérisée par le fait qu'elle comporte des moyens de répartition pour établir une différence de potentiel entre les extrémités de sortie (B) de deux lignes adjacentes et que les moyens de répartition comprennent une diode Zéner (15, 21, 22, 23) connectée entre les extrémités de sortie semblables de deux lignes adjacentes (13/14, 17/18, 18/19, 19/20).

7. Clôture électrifiée selon la revendication 5 caractérisée par le fait que les moyens à seuil de tension (24/25) comprennent une diode Zéner (26, 27) connectée en série avec les dites cellules (24, 25).

8. Clôture électrifiée selon l'une quelconque des revendications 1 à 7 caractérisée par le fait que les cellules comprennent une diode électro-luminescente (8) en série avec une résistance (9) et par le fait que la diode électro-luminescente (8) est couplée aux moyens de traitement (7) par des moyens de liaison optique isolés galvaniquement.

9. Clôture électrifiée selon la revendication 1 caractérisée par le fait que les cellules sont situées en série avec la source d'alimentation (41) du réseau (1) de lignes (4) et qu'elles sont connectées entre la source et l'une des extrémités du réseau.

10. Clôture électrifiée selon la revendication 9 caractérisée par le fait que les cellules (40) comprennent une diode électro-luminescente (43) en série avec une diode Zéner (44) l'ensemble étant en parallèle sur une résistance (42).

**Claims**

1. An electrical fence formed by a network (1) of conductive wires (4), each of the wires comprising on the one hand an input end (A) and on the other hand an output end (B) and conducting a current from a single supply source (2), the network also comprising means for controlling disconnection faults in the wires and insulating faults between the wires, characterised in that the control means are connected via galvanic insulating means to processing means (7) and in that the means for controlling faults comprises fault detection cells (11, 12, 24, 25, 28, 29, 30, 40) arranged in the network in such a manner as to effect a distribution of potentials at the input and output ends (A, B) of the wires (4, 13, 14, 17 to 20), said cells allowing for a control of the distribution at the ends (A, B) of the wires (4, 13, 14, 17 to 20).

2. An electrical fence according to claim 1, characterised in that the fault detection cells comprise active means for transmission towards the processing means (7) and passive means, and in that the entire active means is arranged at one end (A) of the wires (4, 13, 14, 17 to 20) of the network (1).

3. An electrical fence according to claim 1 or 2, characterised in that the control cells are arranged in series with each of the conductive wires (4) upstream of the latter's input end (A) to which the control cells are also connected.

4. An electrical fence according to any one of claims 1 to 3, characterised in that the cells are arranged in the network in such a manner as to produce a difference in potential between at least the input ends (A) of two successive wires (13, 14, 17 to 20) and as to connect the input ends (A) of two successive wires (13, 14, 17 to 20).

5. An electrical fence according to claim 1, characterised in that the wires (4) are electrically connected in pairs (17/18, 19/20) by means of the cells, the latter being connected in series with threshold voltage means and connecting the input ends (A) in such a manner as to produce a difference in potential between the input ends (A) of two electrically connected wires (17/18, 19/20), and in that said threshold is at least equal to the above difference in potential.

6. An electrical fence according to claim 4 or 5, characterised in that the fence comprises distribution means for producing a difference in potential between the output ends (B) of two adjacent wires and in that the distribution means comprise a Zener diode (15, 21, 22, 23) connected between the like output ends of two adjacent wires (13/14, 17/18, 18/19, 19/20).

7. An electrical fence according to claim 5, characterised in that the threshold voltage means (24/25) comprise a Zener diode (26, 27) connected in series with said cells (24, 25).

8. An electrical fence according to any one of claims 1 to 7, characterised in that the cells comprise an electroluminescent diode (8) in series with a resistor (9) and in that the electroluminescent diode (8) is connected to the processing means (7) by galvanically insulated optical connection means.

9. An electrical fence according to claim 1, characterised in that the cells are arranged in series with the supply source (41) of the network (1) of wires (4) and are connected between the source and one of the ends of the network.

10. An electrical fence according to claim 9, characterised in that the cells (40) comprise an electroluminescent diode (43) in series with a Zener diode (44), both being in parallel with a resistor (42).

## Patentansprüche

1. Elektrischer Zaun, der gebildet wird aus einem Netz bzw. Gitter (1) aus Leitungsdrahtlinien (4), wobei jede Linie auf einer Seite ein Eingangsende (A) und auf der anderen Seite ein Ausgangsende (B) aufweist und von einer einzigen Versorgungsquelle (2) aus von elektrischem Strom durchflossen ist, wobei das Gitter des weiteren mit einer Einrichtung zur Kontrolle des Abtrennens der Leitungsdrähte und der Isolierung zwischen den Leitungsdrähten ausgestattet ist, dadurch gekennzeichnet, daß die Kontrolleinrichtung über eine galvanische Isolierungseinrichtung mit einer Verarbeitungseinrichtung (7) verbunden ist und daß die Einrichtung zur Ausfallkontrolle Zellen (11, 12, 24, 25, 28, 29, 30, 40) zur Erfassung bzw. zum Nachweis eines Ausfalls aufweist, die in dem Netz bzw. Gitter derart angeordnet sind, daß sie auf der Ebene der Eingangs- oder Ausgangsenden (A, B) der Leitungsdrähte (4, 13, 14, 17 bis 20) eine Verteilung der Spannungen erzeugen, wobei diese Zellen eine Kontrolle dieser Verteilung auf der Ebene der Enden (A, B) der Leitungsdrähte (4, 13, 14, 17 bis 20) erlauben.

2. Elektrischer Zaun nach Anspruch 1, dadurch gekennzeichnet, daß die Zellen zur Erfassung bzw. zum Nachweis eines Ausfalls eine aktive Einrichtung zur Übertragung in Richtung auf eine Verarbeitungseinrichtung (7) und eine passive Einrichtung aufweisen und daß sich der Komplex der aktiven Einrichtung auf der Seite eines gleichen Endes (A) der Leitungsdrähte (4, 13, 14, 17 bis 20) des Netzes bzw. Gitters (1) befindet.

3. Elektrischer Zaun nach Anspruch 1 oder 2, dadurch gekennzeichnet, daß sich die Kontrollzellen in Reihe mit jedem der Leitungsdrähte (4) befinden, und zwar stromaufwärts des Eingangsendes (A) des Leitungsdrahts, an welchem sie des weiteren angeschlossen sind.

4. Elektrischer Zaun nach einem der Ansprüche 1 bis 3, dadurch gekennzeichnet, daß die Zellen in dem Netz bzw. Gitter derart angeordnet sind, daß sie für einen Spannungsunterschied zwischen wenigstens den Eingangsenden (A) zweier aufeinanderfolgender Leitungsdrähte (13, 14, 17 bis 20) sorgen, und derart, daß sie die Eingangsenden (A) der beiden aufeinanderfolgenden Leitungsdrähte (13, 14, 17 bis 20) verbinden.

5. Elektrischer Zaun nach Anspruch 1, dadurch gekennzeichnet, daß die Leitungsdrähte (4) paarweise (17/18, 19/20) mittels Zellen elektrisch verbunden sind, welche Zellen mit einer Spannungsschwelle in Reihe geschaltet sind und die Eingangsenden (A) derart verbinden, daß zwischen den Eingangsenden (A) der beiden miteinander elektrisch verbundenen Leitungsdrähte (17/18, 19/20) ein Spannungsunterschied gebildet wird, und daß die Schwelle zumindest gleich dem vorgenannten Spannungsunterschied ist.

6. Elektrischer Zaun nach Anspruch 4 oder 5, dadurch gekennzeichnet, daß dieser eine Verteilungseinrichtung zur Bildung eines Spannungsunterschiedes zwischen den Ausgangsenden (B) der beiden benachbarten Leitungsdrähte aufweist und daß die Verteilungseinrichtung mit einer Zenerdiode (15, 21, 22, 23) versehen ist, die zwischen den ähnlichen Ausgangsenden der beiden benachbarten Leitungsdrähte (13/14, 17/18, 18/19, 16/20) angeschlossen ist.

7. Elektrischer Zaun nach Anspruch 5, dadurch gekennzeichnet, daß die Spannungsschwelle (24/25) eine Zenerdiode (26, 27) aufweist, die mit den Zellen (24, 25) in Reihe geschaltet ist.

8. Elektrischer Zaun nach einem der Ansprüche 1 bis 7, dadurch gekennzeichnet, daß die Zellen in Reihe mit einem Widerstand (9) eine LED-Diode (8) aufweisen und daß die LED-Diode (8) durch eine galvanisch isolierte optische Verbindungseinrichtung mit der Verarbeitungseinrichtung (7) verbunden ist.

9. Elektrischer Zaun nach Anspruch 1, dadurch gekennzeichnet, daß die Zellen in Reihe mit der Versorgungsquelle (41) des Netzes bzw. Gitters (1) angeordnet und zwischen der Quelle und einem der Enden des Netzes bzw. Gitters angeschlossen sind.

10. Elektrischer Zaun nach Anspruch 9, dadurch gekennzeichnet, daß die Zellen (40) eine LED-Diode (43) in Reihe mit einer Zenerdiode (44) aufweisen und daß das Ganze mit einem Widerstand (42) parallel geschaltet ist.

Fig:1

Fig:2

Fig:3

Fig:4

Fig:5